# NEUE EUROPÄISCHE PATENTSCHRIFT

(11) **EP 0 212 253 B2**
(45) Veröffentlichungstag und Bekanntmachung des Hinweises auf die Entscheidung über den Einspruch: **11.11.1998**
(45) Hinweis auf die Patenterteilung: 28.02.1990
(21) Anmeldenummer: 86109731.9
(22) Anmeldetag: 16.07.1986
(51) Int. Cl.: H05K 3/42

(54) **Verfahren und Einrichtung zur Reinigung, Aktivierung und/oder Metallisierung von Bohrlöchern in horizontal geführten Leiterplatten**
Process and device for cleaning, activating and/or metallizing bore holes in horizontally transported circuit boards
Procédé et dispositif de nettoyage, d'activation et/ou de métallisation de trous dans des plaquettes de circuit transportées horizontalement

(30) Priorität: 06.08.1985 DE 3528575
(43) Veröffentlichungstag der Anmeldung: 04.03.1987
(73) Patentinhaber: ATOTECH Deutschland GmbH, 10553 Berlin (DE)
(72) Erfinder: Bläsing, Horst, D-1000 Berlin 13 (DE); Meyer, Walter, D-1000 Berlin 28 (DE)
(74) Vertreter: TER MEER STEINMEISTER & PARTNER GbR

(56) Entgegenhaltungen:
- EP-B- 78 900
- DE-A- 1 935 707
- DE-A- 2 606 984
- DE-C- 3 001 726
- DE-C- 3 305 564
- FR-A- 2 301 307
- US-A- 3 386 166
- US-A- 3 705 457
- GALVANOTECHNIK, Band 74, Nr. 10, 1983, Seiten 1259-1264, Saulgau, DE; G.MÜLLER: "Maschinelle chemische Lochwandreinigung im Durchlaufverfahren"
- IBM TECHNICAL DISCLOSURE BULLETIN, Band 20, Nr. 3, August 1977, Seite 962, New York, US; J.C.LO et al.: "Ultrasonic chemical method of cleaning blind holes in a printed-circuit board"
- H.-J-EHRICH: "Moderne Aspekte zur Lochwandreinigung mit permanganhaltigen Lösungen"
- H.-J-EHRICH, 'elektrotechnik', 69, H.20, 7.Dezember 1987, Seiten 32-37: "Kleine Löcher kein Problem"
- G.MÜLLER-ENSSLIN, GEBRÜDER SCHMID GmbH & CO KG, Leiterplatten-Seminar 1981, Seiten 2-3
- Proceedings of the Printed Circuit World Convention Vol.1, June 9th-12th 1981, Seiten 328-331
- G.MÜLLER-ENSSLIN: "New Technologies in Conveyorized Horizontal Solder-Coater-Levelling Systems (Hot-Air-Levelling)
- EPM HANDELS AG, Heissverzinnanlage epm PV 4070
- Metalloberfläche 40 (1986), 11, Seiten 459-464, H.-J. EHRICH: "Bohrlochreinigung durch Ätzen (Smear-Removal-Verfahren)
- GERTHSEN-KNESER (1969), Seiten 107-108

## Beschreibung

Die Erfindung betrifft ein Verfahren zur Reinigung, Aktivierung und/oder chemischen Metallisierung von Bohrlöchern in horizontal geführten Leiterplatten und eine Einrichtung zur Durchführung dieses Verfahrens.

Leiterplatten für gedruckte Schaltungen, die durch Bohrlöcher die beiden Oberflächen oder Leiterbahnen innerhalb der Isolierung nach der Aktivierung und Metallisierung, dem sogenannten Durchkontaktisierungsprozess, miteinander verbinden, sind in ihrer Funktionsfähigkeit in hohem Maße davon abhängig, ob die jeweiligen Verunreinigungen exakt entfernt werden können.

Verfahren und Einrichtungen zum Reinigen von derartigen Kontaktierungslöchern in Leiterplatten sind bereits bekannt (DE-PS-2 606 984). Diese Verfahren und Einrichtungen weisen indessen relativ niedrige Durchströmgeschwindigkeiten verbunden mit längeren Behandlungszeiten auf, was verbesserungsbedürftig ist.

Aus Galvanotechnik, Band 74, Nr. 10, 1983, Seiten 1259 - 1264 ist weiterhin ein Verfahren zur Reinigung von Bohrlöchern in horizontal geführten Leiterplatten bekannt, bei dem die Leiterplatte mit konstanter Geschwindigkeit über eine Schwallstrecke hinwegläuft, die von einer unterhalb der Transportbahn senkrecht zur Transportrichtung angeordneten Düse erzeugt wird. Die Reinigungswirkung dieses Verfahrens nimmt zu kleineren Lochdurchmessem ab, so daß lediglich Bohrungen mit 0,5 mm Durchmesser problemlos gereinigt werden können.

Aufgabe der vorliegenden Erfindung ist die Zurverfügungstellung eines Verfahrens und einer Vorrichtung, welche eine exakte Reinigung und Behandlung von kleineren Bohrlöchern als im Stand der Technik in Leiterplatten mit hohen Durchströmgeschwindigkeiten in kurzen Behandlungszeiten ermöglichen.

Diese Aufgabe wird erfindungsgemäß gelöst durch das im Anspruch 1 definierte Verfahren und die Einrichtung gemäß Anspruch 3.

Vorteilhafte Weiterbildungen sind in den Unteransprüchen beschrieben.

Das erfindungsgemäße Verfahren ermöglicht in bisher nicht erreichter Weise eine absolute Reinigung von Lochinnenwandungen in Leiterplatten innerhalb außerordentlich kurzer Behandlungszeiten.

Das Verfahren eignet sich außerdem auch zur Aktivierung und chemischen Metallisierung dieser Bohrlöcher unter Verwendung üblicher Aktivierungs- und Metallisierungslösungen.

Von besonderem Vorteil ist es, daß sogar kleinste Bohrlochdurchmesser bis zu 0,15 mm sicher konditioniert, aktiviert und/oder metallisiert werden können.

Weitere Vorteile bestehen darin,
- daß die chemische Metallisierung, zum Beispiel die chemische Verkupferung, infolge des Wegfalls anhaftender Wasserstoffbläschen sehr verbessert wird,
- daß die meisten Prozeßstufen ohne Beheizung durchgeführt werden können und
- daß eine Gestellentmetallisierung entfällt.

Als flüssige Reinigungsmittel können zum Beispiel Wasser, Säuren, wie Schwefelsäure, oder Basen Verwendung finden. Zur Aktivierung lassen sich hierfür übliche Aktvierungslösungen, zum Beispiel auf Basis von Edelmetallösungen, wie Palladiumsalzlösungen, einsetzen.

Für die chemische Metallisierung können ebenfalls hierfür übliche Badlösungen verwendet werden.

Ausführungsbeispiele der Erfindung werden anhand der folgenden Figuren näher beschrieben.

Es stellt dar:

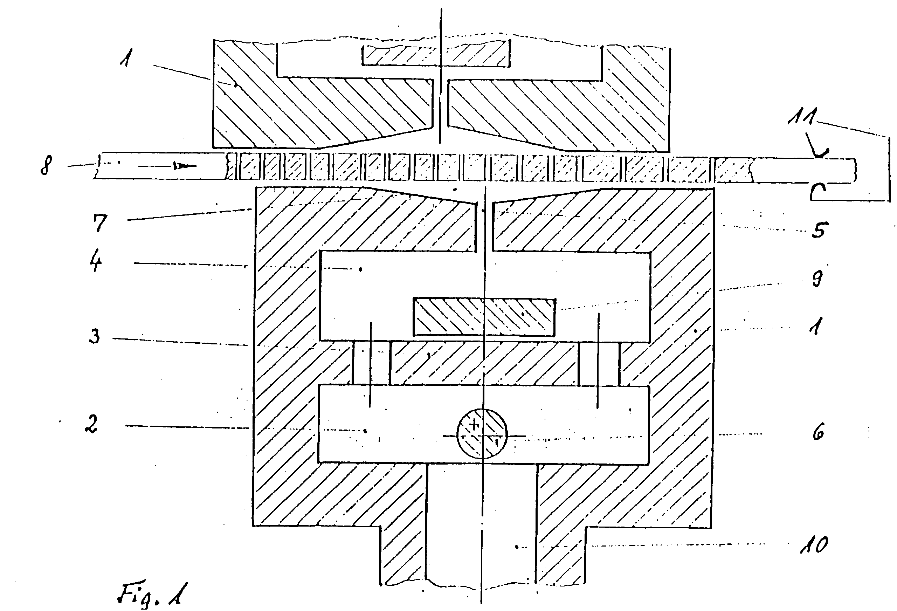

- Figur 1:: einen Querschnitt durch die Einrichtung

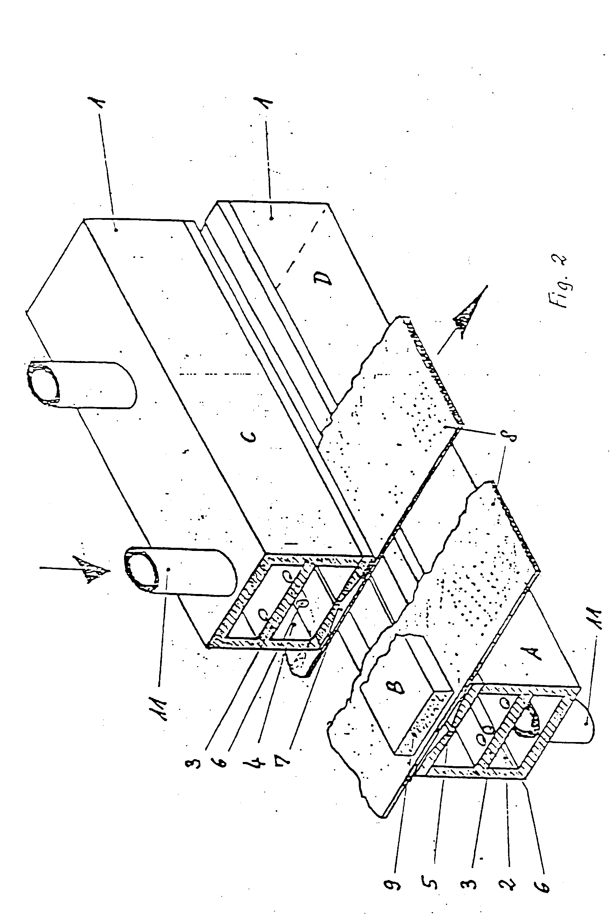

- Figur 2:: eine perspektivische Darstellung der Einrichtung

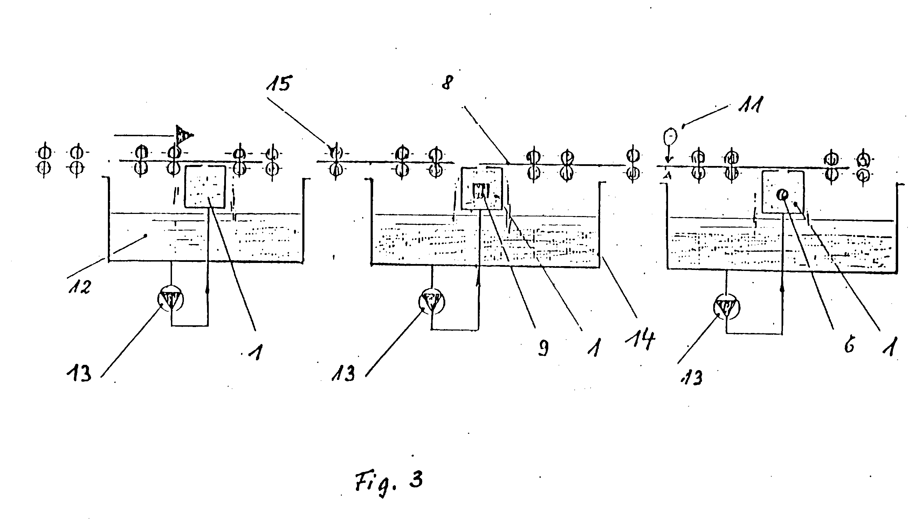

- Figur 3:: eine schematische Darstellung der Verfahrensstufen

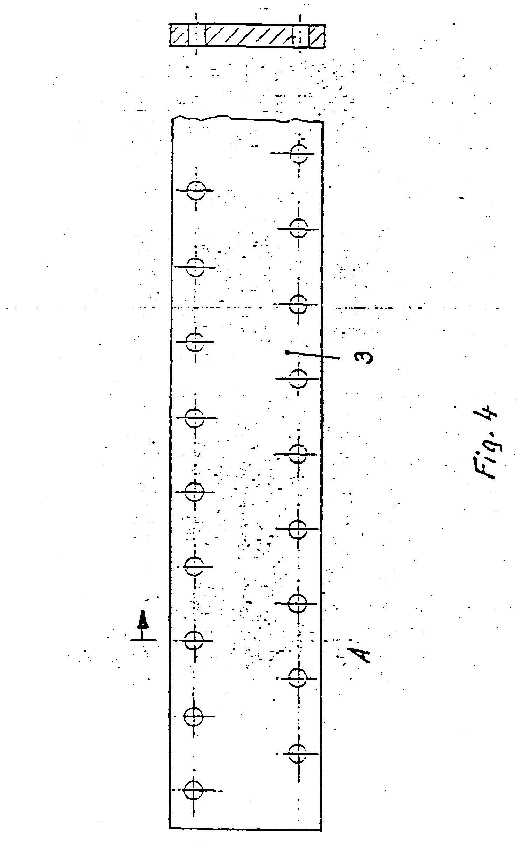

- Figur 4:: eine Drauf- und eine Seitenansicht der Lochmaske.

Hierein bedeuten;
- 1: Düsengehäuse
- 2: Vorkammer
- 3: Lochmaske
- 4: Düseninnenraum
- 5: Düse
- 6: Anode
- 7: Raum zwischen Düsengehäuse und Leiterplatte (8)
- 8: Leitetplatte
- 9: Ultraschallschwinger
- 10: Einlaufstutzen
- 11: Schleifkontakte
- 12: Behandlungslösung
- 13: Pumpe
- 14: Behälter
- 15: Führungsrollen

- A: Einrichtung unterhalb der Leiterplattenebene
- A + B: Einrichtung mit Ultraschallschwinger (9)
- A + C: zwei Einrichtungen einander gegenüber senkrecht oder versetzt positioniert
- A + B + C: zwei Einrichtungen einander gegenüber positioniert mit Ultraschallschwinger (9)
- A + D: Einrichtung mit Elektrolyse (D) (Anode + Kathode)
- A + C + D: zwei Einrichtungen gegenüber positioniert mit Elektrolyse (D) (Anode + Kathode)

Die Arbeitsvorgänge laufen beim Betrieb im wesentlichen wie folgt ab:

Durch mehrere Einlaufstutzen (10) wird die Behandlungslösung, wie zum Beispiel Wasser, in die Vorkammer (2) geleitet. Der Düseninnenraum ist durch eine Lochmaske (3) geteilt, durch die eine Verteilung der Strömung zur Düse erzielt wird. Der Düseninnenraum (4) vor der Schlitzdüse dient als Stauraum für eine gleichmäßige Ausbildung des Schwalls nach Passieren der Düse (5). Im Raum (7) zwischen dem Düsengehäuse (1) und der Leiterplatte (8) entsteht ein Überdruck, der die Lösung auch über den Bereich der hohen Strömung hin durch die Bohrlöcher zwingt. Im Fall der chemischen Behandlung der Leiterplatten wird nur mit der unteren Schwalldüse gearbeitet. Bei Reinigungsprozessen mit Ultraschall und elektrochemischen Prozessen wird mit zwei Schwalldüsen, die jeweils versetzt auf der Ober- und Unterseite der Leiterplatte positioniert sind, gearbeitet. In diesen Fällen ist in der Schwalldüse beziehungsweise oberhalb der Leiterplatte ein Ultraschallschwinger (9) installiert. Für die Elektrolyse ist eine Anode (6) im Innenraum fixiert. Die negative Polarisation der Leiterplatte (8) erfolgt über Schlsifkontakte (11), die außerhalb des Naßbereichs vor und nach den Düsen positioniert sind.

Das erfindungsgemäße Verfahren eignet sich insbesondere für die Behandlung von Leiterplatten für gedruckte Schaltungen, die in der Elektrotechnik Verwendung finden.

## Patentansprüche

1. Verfahren zur Reinigung, Aktivierung und/oder chemischen Metallisierung von Bohrlöchern in horizontal geführten Leiterplatten (8), wobei die Leiterplatte mit konstanter Geschwindigkeit über eine Schwallstrecke hinwegläuft, die gebildet wird von einer unterhalb und senkrecht zu der Transportbahn angeordneten, der Förderung eines flüssigen Behandlungsmittels an die Unterseite der Leiterplatte dienenden Düse (5), dadurch gekennzeichnet, daß
- als Behandlungsmittel zur Reinigung ein flüssiges Reinigungsmittel, zur Aktivierung eine Edelmetallösung und/oder zur chemischen Metallisierung eine Badlösung verwendet wird,
- das flüssige Behandlungsmittel in Form einer stehenden Welle gefordert wird,
- und eine Düsenöffnung verwendet wird, die die Form einer perforierten Ebene hat, die durchbrochen, geschlitzt oder gelocht ist, und die Außenfläche des Düsengehäuses eine konische Ausnehmung beidseits der Düsenöffnung aufweist, derart, daß im Raum zwischen Düsengehäuse und Leiterplatte ein Überdruck entsteht, der das flüssige Behandlungsmittel auch über den Bereich der hohen Strömung hin durch die Bohrlöcher zwingt.

2. Verfahren gemäß Anspruch 1, **dadurch gekennzeichnet,** daß die Leiterplatten (8) in einem Abstand von 1 mm oberhalb der Düse (5) positioniert werden.

3. Einrichtung zur Durchführung des Verfahrens nach einem der Ansprüche 1 oder 2 mit einer Transporteinrichtung zur horizontalen Führung von Leiterplatten (8) mit konstanter Geschwindigkeit, mit einer unterhalb und senkrecht zu der Transportbahn angeordneten Düse (5) sowie mit einer Pumpe (13) zur Förderung eines flüssigen Behandlungsmittels (12) aus der Düse an die Unterseite der Leiterplatte,
dadurch gekennzeichnet,
daß die Düse (5) im oberen Teil eines Düsengehäuses (1) angeordnet ist, das eine Vorkammer (2) mit Einlaufstutzen (10) aufweist, die mittels einer Lochmaske (3) vom oberen Teil des Düseninnenraumes (4) abgetrennt ist und die Düsenöffnung in Form einer perforierten Ebene vorliegt, die geschlitzt gelocht oder durchbrochen ist, und die Außenfläche des Düsengehäuses eine konische Ausnehmung beidseits der Düsenöffnung aufweist, derart, daß im Raum zwischen Düsengehäuse und Leiterplatte ein Überdruck entsteht, der das flüssige Behandlungsmittel auch über den Bereich der hohen Strömung hin durch die Bohrlöcher zwingt.

4. Einrichtung gemäß Anspruch 3, dadurch gekennzeichnet, daß innerhalb des Düsengehäuses (1), vorzugsweise in dessen oberen Teil, ein Ultraschallschwinger (9) angeordnet ist

5. Einrichtung gemäß Anspruch 3, dadurch gekennzeichnet, daß diese zwei Düseneinrichtungen aufweist, die versetzt auf der Ober- und Unterseite der Leiterplatte (8) angeordnet sind.

6. Einrichtung gemäß Anspruch 3, dadurch gekennzeichnet, daß im Düsengehäuse (1), vorzugsweise im unteren Teil, eine Anode (6) fixiert ist.

## Claims

1. Method for cleaning, activation and/or chemical metalplating of holes in horizontally guided circuit boards (8), the circuit board running at a constant speed through a flow treatment section which is formed by a jet (5) arranged beneath and perpendicular to the path of transport, this jet being adapted to issue a liquid treatment agent against the lower side of the circuit board,
characterized in that
- a liquid cleanser is used as a treatment agent for cleaning, a precious metal solution is used for activation and/or a bath solution is used for chemical metalplating,
- the liquid treatment agent is conveyed as a stationary wave,
- and a jet orifice is used which is designed as a perforated plane with perforations, holes or slits, and the outer surface of the jet casing unit has a conical recess on both sides of said jet orifice so that overpressure is produced in the space between the jet casing unit and the circuit board, said overpressure urging the liquid treatment agent also across the region of high flow through the holes.

2. Method in accordance with Claim 1, characterized in that the circuit boards (8) are positioned at a distance of 1 mm above the jet (5).

3. Device for performing the method in accordance with Claim 1 or 2 with a transport arrangement for horizontal guidance of circuit boards (8) at constant speed, with a jet (5) beneath and perpendicular to the transport track and with a pump (13) for conveying a liquid treatment agent (12) from the jet to the lower side of the circuit board,
characterized in
that the jet (5) is arranged in the upper part of a jet casing unit (1) which possesses an antechamber (2) with inflow sleeve (10) separated from the upper part of the interior of the jet (4) by a perforated mask (3) and the jet orifice is designed as a perforated plane with slits, holes or perforations and the outer surface of the jet casing unit has a conical recess on both sides of the jet orifice so that overpressure is produced in the space between the jet casing unit and the circuit board, said overpressure urging the liquid treatment agent also across the region of high flow through the holes.

4. Device in accordance with claim 3, characterized in that an ultrasonic resonator (9) is arranged within the jet casing unit (1) preferably in its upper part.

5. Device in accordance with Claim 3, characterized in that this possesses two jet systems which are arranged in an offset manner on the upper and lower sides of the circuit board (8).

6. Device in accordance with Claim 3, characterized in that an anode (6) is fixed in the jet casing unit (1), preferable in the bottom part.

## Revendications

1. Procédé de nettoyage, d'activation et/ou de métallisation chimique des forures de plaquettes conductrices (8) guidées en sens horizontal, la plaquette passant à vitesse constante au-dessus d'une section à jet d'eau formée par une buse (5) placée en-dessous de la bande transporteuse et perpendiculairement au sens de transport, buse qui amène un produit de traitement liquide sur le dessous de la plaquette conductrice, ledit procédé étant caractérisé par le fait que :
- le produit de traitement pour le nettoyage est un moyen de nettoyage liquide, pour l'activation d'une solution de métal précieux et/ou pour la métallisation chimique d'une solution de bain,
- le moyen de traitement liquide est fourni sous la forme d'une onde stationnaire,
- et on utilise une ouverture de buse qui se présente sous la forme d'un plan perforé, fendu ou ajouré, et la surface extérieure du corps de la buse comporte un évidement conique de chaque côté de l'ouverture de la buse de telle sorte que, dans l'espace situé entre le corps de buse et la plaquette conductrice apparaisse une surpression, qui force le moyen de traitement liquide à traverser les forures même dans la zone de flux élevé.

2. Procédé selon la revendication 1, caractérisé en ce que les plaques conductrices (8) sont positionnées au dessus de la buse (5) avec un écartement de 1mm.

3. Installation pour la mise en oeuvre du procédé selon l'une des revendications 1 et 2, comportant une installation de transport pour le guidage horizontal des plaquettes conductrices (8) à vitesse constante, une buse (5) placée en dessous de la bande transporteuse et perpendiculairement à la voie de transport ainsi qu'une pompe (13) pour fournir un moyen de traitement liquide (12) depuis la buse jusqu'au dessous de la plaquette conductrice, caractérisée en ce que :
la buse (5) est logée dans la partie supérieure d'un corps de buse (1) présentant un compartiment avant (2) avec une tubulure d'entrée (10) séparée de la partie supérieure de l'intérieur de la buse (4) par un masque perforé (3), en ce que l'ouverture de la buse se présente sous la forme d'un plan perforé, fendu ou ajouré, et en ce que la surface extérieure du corps de buse comporte un évidement conique de chaque côté de l'ouverture de la buse, de telle sorte que dans l'espace situé entre le corps de buse et la plaque conductrice apparaisse une surpression, qui force le moyen de traitement liquide à s'écouler à travers les forures même dans la zone des flux élevés.

4. Installation selon la revendication 3, caractérisée par le fait qu'à l'intérieur du corps de la buse (1) et de préférence dans sa partie supérieure est logé un oscillateur ultrasonore (9).

5. Installation selon la revendication 3, caractérisée par le fait qu'elle présente deux dispositifs à buse disposés en déport sur le dessus et sur le dessous de la plaquette conductrice (8).

6. Installation selon la revendication 3, caractérisée en ce qu'une anode (6) est fixée dans le corps de la buse (1), de préférence dans sa partie inférieure.
